# EUROPÄISCHE PATENTSCHRIFT

(11) **EP 1 279 941 B1**
(45) Veröffentlichungstag und Bekanntmachung des Hinweises auf die Patenterteilung: **10.01.2007**
(21) Anmeldenummer: 02011789.1
(22) Anmeldetag: 28.05.2002
(51) Int. Cl.: G01M 3/16, G01M 3/18, G01R 27/26

(54) **Verfahren zur Dichtigkeitsprüfung von kapazitiven Sensoren**
Procedure for testing the leak tightness of capacitive sensors
Procédé d'essai de l'étanchéité de capteurs capacitifs

(30) Priorität: 25.07.2001 DE 10136219
(43) Veröffentlichungstag der Anmeldung: 29.01.2003
(73) Patentinhaber: Conti Temic microelectronic GmbH, 90411 Nürnberg (DE)
(72) Erfinder: Cramer, Wolfgang, 73277 Owen-Teck (DE)

(56) Entgegenhaltungen:
- DE-A1- 10 035 564
- DE-A1- 19 616 014
- DE-A1- 19 924 369
- US-A- 5 872 309
- US-B1- 6 201 284
- PATENT ABSTRACTS OF JAPAN Bd. 1995, Nr. 10, 30. November 1995 (1995-11-30) & JP 07 183543 A (HITACHI LTD), 21. Juli 1995 (1995-07-21)

## Beschreibung

Die Erfindung betrifft ein Verfahren zur Dichtigkeitsprüfung von in einem hermetisch dichten Gehäuse angeordneten kapazitiven Sensoren nach dem O-berbegriff des Patentanspruchs 1.

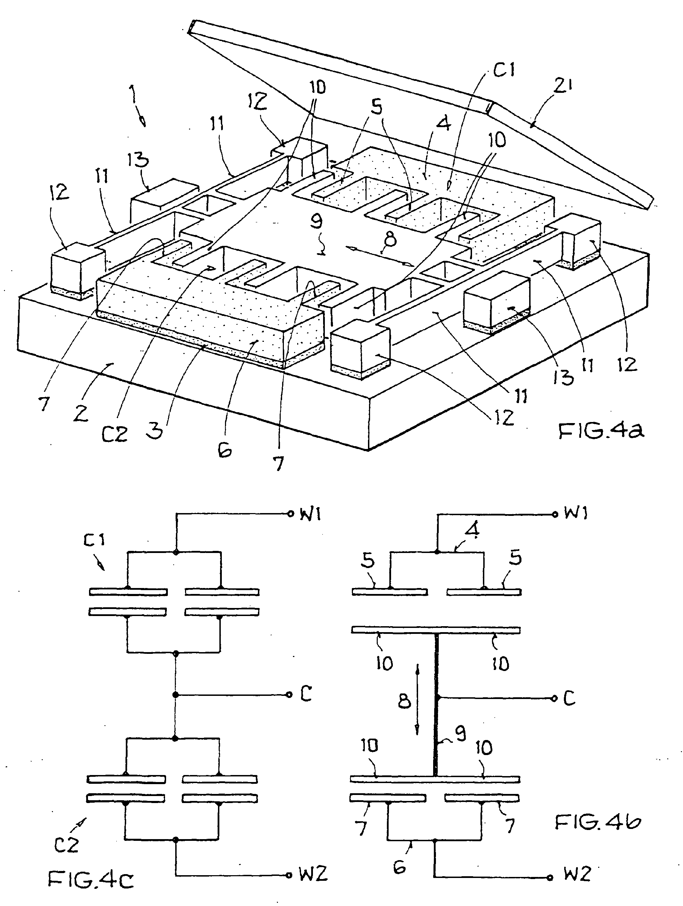

In Oberflächen-Mikromechanik hergestellte Beschleunigungssensoren arbeiten häufig nach dem kapazitiven Messprinzip. Ein derartiger Beschleunigungssensor ist in Fig. 4a dargestellt. Das kapazitive Messprinzip besteht darin, dass eine bewegliche Probemasse mit seitlich angebrachten Elektrodenkämmen (sogenannten moving finger) an winzigen Siliziumfedern aufgehängt ist, so dass sie bei Beschleunigungen in der sensitiven Richtung ausgelenkt wird. Dabei wird die Kapazität zwischen den festen und den beweglichen Elektroden auf einer Seite der Probemasse erhöht und auf der anderen Seite erniedrigt. Die elektrisch voneinander isolierten Sensorfinger bilden somit einen differentiellen Kondensator mit einer Kapazität um 600 fF.

Für die prozessierten Wafer ist als Schutz gegen Feuchte, Partikel und sonstige mechanische Einflüsse eine Abdeckung in Form eines hermetisch abdichtenden Deckels aus Silizium oder einem ähnlichen Material unbedingt erforderlich.

Bekannte Leck- und Dichtigkeitsprüfverfahren zum Prüfen der Hermeticität nach MIL- oder EN-Norm (zum Beispiel "bubble test" oder "Gross Leak" nach MIL-Methode 1014) können aufgrund des extrem geringen Volumens der Sensorkavität nicht angewendet werden. Andere bekannte Dichtheits-Prüfverfahren (siehe Dokumente US-A-5 872 309 oder DE-A-19 924 369) sind entweder auf Waferebene nicht anwendbar oder wegen ihres hohen Risikos beispielsweise wegen der Verwendung von Radioisotopen wie Krypton 85 nur unter hohem Sicherheitsaufwand möglich und daher wegen zu hoher Kosten für die Serienproduktion nicht einsetzbar.

Der Erfindung liegt daher die Aufgabe zugrunde, ein Prüfverfahren nach dem Oberbegriff des Anspruchs 1 anzugeben, mit dem kapazitive Sensoren kostengünstig, zuverlässig und auf umweltfreundliche Art und Weise auf Dichtigkeit geprüft werden können.

Gelöst wird diese Aufgabe durch ein Verfahren mit den im Anspruch 1 angegebenen Merkmalen.

Das Verfahren nach Anspruch 1 weist die Vorteile auf, dass durch die in die Kavität eindringende Prüfflüssigkeit mit definierten dielektrischen Eigenschaften kleinste Undichtigkeiten bis in den sogenannten "Gross-Leak-Bereich" (10⁻³ bis 10⁻⁵ mbar·dm³·s⁻¹) durch deutlich messbare Kapazitätsänderungen erkannt werden. Ein weiterer Vorteil besteht darin, dass die Prüfmethode als "In-Line-Prüfverfahren" anwendbar ist, d.h. die Dichtheits-Prüfung ist auf Waferebene als 100 %-Prüfung in den normalen Wafertest ohne zusätzlichen Prüfzeitaufwand integrierbar. Weiterhin sind durch die Verwendung der Prüfflüssigkeiten keine negativen Auswirkungen (Schädigung durch Oxidation, Korrosion etc.) auf den Prüfling zu erwarten. Eine Reaktion mit der auf Folie aufgespannten Wafer ist ebenfalls nicht zu erwarten.

Die Erfindung eignet sich insbesondere zur Leck- und Dichtigkeitsprüfung für mikromechanisch aufgebaute und hermetisch abgeschlossene kapazitive Sensoren, insbesondere Beschleunigungssensoren.

Vorteilhafte Ausgestaltungen des Verfahrens nach Anspruch 1 sind in den Unteransprüchen angegeben.

Die Erfindung wird nun anhand eines Ausführungsbeispiels unter Zuhilfenahme der Zeichnung erläutert.

Es zeigen
- Fig. 1:: den typischen Verlauf der Kapazität über der Spannung eines dichten Beschleunigungssensors,
- Fig. 2:: den typischen Verlauf der Kapazität über der Spannung eines undichten Beschleunigungssensors mit hoher Leckrate,
- Fig. 3a:: den typischen Verlauf der Kapazität über der Spannung eines undichten Beschleunigungssensors mit niedriger Leckrate und
- Fig. 3b:: eine Ausschnittsvergrößerung des Verlaufs nach Fig. 3a,
- Fig. 4a:: der prinzipielle Aufbau eines mikromechanischen Beschleunigungssensors,
- Fig. 4b:: die prinzipielle Wirkungsweise des Beschleunigungssensors nach Fig. 4a und
- Fig. 4c:: das Ersatzschaltbild für den Beschleunigungssensor nach Fig. 4a.

Die **Fig. 4a** zeigt den prinzipiellen Aufbau eines mikromechanisch hergestellten, kapazitiven Beschleunigungssensors **1.** Auf einem n-leitenden Substrat **2** (Bodenwafer) und einer isolierenden SiO₂-Schicht **3** sind als eine erste Kapazität **C1** eine erste feste Kamm-Elektrode **4** mit Fingern **5** und als eine zweite Kapazität **C2** eine zweite feste Kamm-Elektrode **6** mit Fingern **7** angeordnet. Zwischen der ersten festen Kamm-Elektrode **4** und der zweiten festen Kamm-Elektrode **6** befindet sich eine in Richtung eines Pfeils **8** bewegliche Elektrode **9** mit Fingern **10** als seismische Masse. Die bewegliche Elektrode **9** ist mittels zweier Arme **11** an zwei festen Halteblöcken **12** befestigt. Ein Anschlag **13** verhindert, dass die Finger **10** die Finger **5** bzw. **7** berühren. Schließlich sorgt eine Abdeckung in Form eines hermetisch abdichtenden Deckels **21** aus Silizium oder ähnlichen Materialien dafür, dass der kapazitive Beschleunigungssensor **1** gegen äußere Einflüsse geschützt ist.

Wirkt auf die bewegliche Elektrode **9** als seismische Masse eine Beschleunigungskraft ein, so wird sie in ihrer sensitiven Richtung gemäß des Pfeils **8** ausgelenkt. Dabei wird die eine der beiden Kapazitäten **C1** bzw. **C2** zwischen der beweglichen Elektrode **9** und der festen Kamm-Elektrode **4** bzw. **6** erhöht, während gleichzeitig die andere der beiden Kapazitäten **C1** bzw. **C2** erniedrigt wird.

Diese prinzipielle Wirkungsweise ist in **Fig. 4b** dargestellt. Die Finger **5** der ersten festen Kamm-Elektrode **4** bilden die Kapazität **C1,** während die Kapazität **C2** von den Fingern **7** der zweiten festen Kamm-Elektrode **6** gebildet wird. Die Kapazität **C1** wird zwischen einem Anschluss **W1** (wall 1) der ersten festen Kamm-Elektrode **4** und einem Mittelabgriff **c** (center) der beweglichen Elektrode **9** gemessen, die Kapazität **C2** zwischen einem Anschluss **W2** (wall 2) der zweiten festen Kamm-Elektrode **6** und dem Mittelabgriff **c** der beweglichen Elektrode **9**.

Bei der durch Beschleunigungskräfte verursachten Bewegung der beweglichen Elektrode **9** in Richtung des Pfeils **8** verändern sich die Kapazitäten **C1** und **C2** auf bereits beschriebene Art und Weise. Die elektrisch von einander isolierten Finger **5**, **7** bzw. **10** bilden einen differentiellen Kondensator mit einer Kapazität von einigen hundert fF bis ungefähr 600 fF.

Daraus ergibt sich für den Beschleunigungssensor **1** das in **Fig. 4c** dargestellte Ersatzschaltbild, bestehend aus den veränderlichen Kapazitäten **C1** und **C2,** wobei sich jede Kapazität **C1** und **C2** aus wenigstens zwei parallel geschalteten Kapazitäten zusammen setzt. Erhöht sich aufgrund von Beschleunigungskräften die Kapazität **C1** um einen bestimmten Wert, erniedrigt sich die Kapazität **C2** um diesen Wert und umgekehrt.

### Ablauf der elektrischen Prüfmethode

Die Deckel **21** der fertig prozessierten Wafer werden entweder bis zum Bodenwafer **2** als Sensorelemente oder die Sensoren **1** als DIE's komplett auf der Wafersäge frei gesägt. Anschließend wird der gesägte Wafer in einen Behälter gebracht und darin einem Vakuum von 5·10⁻¹ mbar eine halbe Stunde lang ausgesetzt. Nach der Flutung mit einer geeigneten Prüfflüssigkeit, beispielsweise mit Flourinert Dielektrika Typ 3M FC40 (DK 1,9), FC72, FC75 oder FC77, ist der Prüfling einer weiteren halben Stunde lang dem Vakuum ausgesetzt. Hierbei muss der Wafer vollständig von der Prüfflüssigkeit umschlossen sein.

Nach dem Ausgleichen des Vakuums auf Normaldruck verbleibt der Wafer im gleichen Behälter und ist in das gleiche Prüfmedium eingetaucht. Danach wird ein definierter Überdruck im Behälter von 8 bar erzeugt und der Prüfling 1 Stunde lang diesen Bedingungen ausgesetzt.

Die Entnahme des Prüflings (Wafer) erfolgt nach Abpumpen der Prüfflüssigkeit und dem Öffnen des Behälters. Zweckmäßig sind zwei Minuten Abtropfzeit bei Schräglage des Wafers, bevor der Wafer aus dem Behälter entnommen wird. Nach einem leichten Abblasen des Wafers mit einem Stickstoffstrahl wird der Wafer zum Trocknen bei Raumtemperatur in einer Stickstoffbox gelagert. Nicht vollständig von der Oberfläche des Wafers entfernte Prüfflüssigkeit verdampft hierbei innerhalb einer Zeit von 15 Minuten rückstandsfrei. Eine elektrische Prüfung des Wafers (Wafertest) muss nun innerhalb von 12 Stunden erfolgen.

### Wafertest

Wie schon erwähnt, wird eine undichte Sensorkavität durch Zunahme der Sensor-Kapazität messtechnisch mittels eines LCR-Meters unter den festgelegten Testkonditionen erkannt (f=400 kHz; U=0,5 Vᵣₘₛ für C [Kapazität] und C_{pD} [Kapazität mit Dissipation Faktor, Ersatzschaltung mit einem angenommenen Parallelwiderstand zum Kondensator]).

Je nach verwendeter Prüfflüssigkeit mit einer bestimmten Dielektrizitätskonstanten (DK) ist bei größeren Leckraten (ca. 10⁻² mbar·dm³·s⁻¹) durch Eindringen der Prüfflüssigkeit mit einer fast vollständigen Benetzung der Sensorfingerstruktur zu rechnen. Die Kapazität der Sensorfinger **5**, **7**, **10** in Ruhelage erhöht sich hierbei um den Faktor DK. Die Kapazitätszunahme unterscheidet sich hierbei deutlich von dichten Referenzsensoren und ist als eindeutiges Prüfkriterium innerhalb des Wafertests anwendbar.

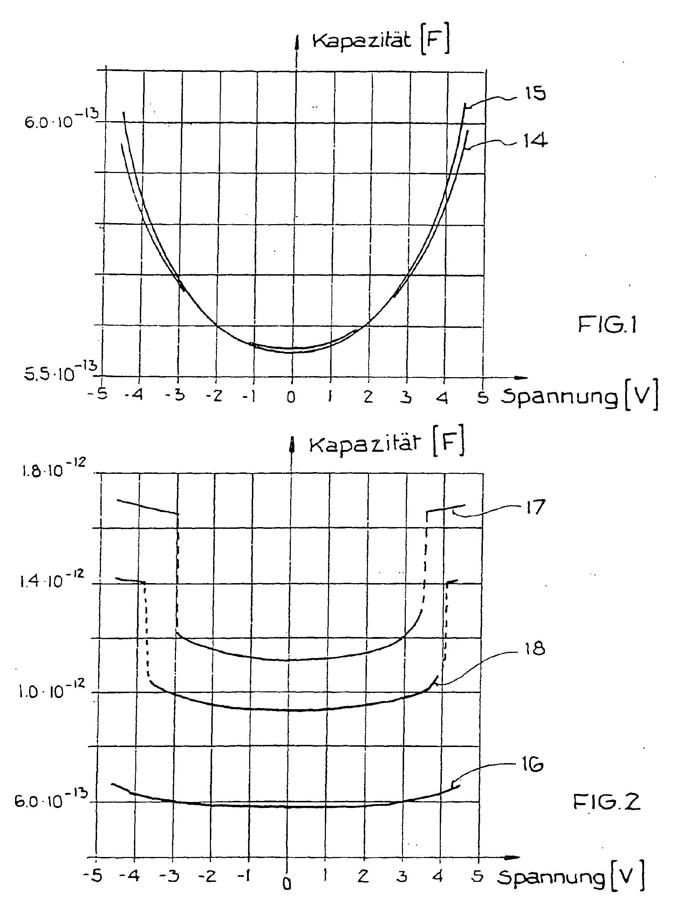

In **Fig. 1** ist der typische Verlauf der Kapazität über der Spannung eines dichten Beschleunigungssensors **1** dargestellt, seine sogenannte CV-Charakteristik (C steht für die Kapazität, V steht für die Spannung). Dabei zeigt eine erste Kurve **14** die zwischen dem Messpunkt **W1** und dem Mittelabgriff **c** gemessene Kapazität des ersten veränderbaren Kondensators **C1** und eine zweite Kurve **15** die zwischen dem Messpunkt **W2** und dem Mittelabgriff **c** gemessene Kapazität des zweiten veränderbaren Kondensators **C2.** Beide Messungen zeigen für beide veränderbare Kondensatoren **C1** und **C2** einen zur Spannungsachse symmetrischen Verlauf der Sensorcharakteristik.

In **Fig. 2** sind drei Kurvenverläufe der Kapazität über der Spannung eines undichten Beschleunigungssensors **1** mit hoher Leckrate (ca. 10⁻² mbar·dm³·s⁻¹) dargestellt. Eine erste Kurve **16** zeigt den Verlauf der veränderbaren Kapazität **C1** oder **C2,** bevor der Beschleunigungssensor **1** der beschriebenen Dichtigkeitsprüfung unterzogen worden ist. Die Kurve **16** zeigt einen zur Spannungsachse symmetrischen Verlauf der Sensorcharakteristik.

Eine zweite Kurve **17** zeigt den Verlauf der veränderbaren Kapazität **C1** oder **C2**, unmittelbar nachdem der Beschleunigungssensor **1** der beschriebenen Dichtigkeitsprüfung unterzogen worden ist. Die Kurve **17** zeigt einen zur Spannungsachse deutlich unsymmetrischen Verlauf der Sensorcharakteristik, wobei ein sehr steiler Anstieg der Kapazität einerseits bei +3,3 V und andererseits bei ―2,8 V erfolgt. Durch Eindringen der Prüfflüssigkeit hat sich die Kapazität der veränderbaren Kondensatoren **C1** oder **C2** ungefähr verdoppelt.

Eine dritte Kurve **18** zeigt den Verlauf der veränderbaren Kapazität **C1** oder **C2**, **48** Stunden nachdem der Beschleunigungssensor **1** der beschriebenen Dichtigkeitsprüfung unterzogen worden ist. Die Kurve **18** zeigt wiederum einen zur Spannungsachse deutlich unsymmetrischen Verlauf der Sensorcharakteristik, wobei ein sehr steiler Anstieg der Kapazität einerseits bei +4,0 V und andererseits bei ―3,6 V erfolgt. Aus dem Verlauf der Kurve **18** geht hervor, dass auch **48** Stunden nach Durchführen des beschriebenen Dichtigkeitstests ein undichter Beschleunigungssensor **1** noch sicher von einem dichten unterschieden werden kann.

Für kleinere Leckraten im Bereich von ca. 10⁻⁴ mbar·dm³·s⁻¹ ist eine erweiterte elektrische Prüfmethode erforderlich, wie sie im folgenden beschrieben wird.

### Ablauf der erweiterten elektrischen Prüfmethode

Das Wirkprinzip der erweiterten elektrischen Prüfmethode ist, dass winzige eingedrungene Partikel der Prüfflüssigkeit auf den Sensorfingern **5, 7** und **10** (Fig. 4a, b) haften bleiben. Durch Influenz werden diese Flourinert Dielektrika im elektrischen Feld polarisiert. Eindringende Partikel der Prüfflüssigkeit bewirken eine elektrisch messbare Beeinflussung der Sensorcharakteristik.

Während der Kapazitätsmessung wird eine zusätzliche Gleichspannung (Bias) der Mess-Wechselspannung überlagert. Hierbei wird die bewegliche Sensorstruktur **9** mit ihren Fingern (moving finger) **10** durch das erzeugte elektrische Kraftfeld bis in den Bereich des Anschlags **13** (over force stopper) bewegt.

Die hierzu erforderliche Bias-Spannung liegt bei den gemessenen Sensoren **1** bei 4,5 Volt und prüft das Sensorverhalten in beiden Polaritätsrichtungen (+4,5V und ―4,5V). Die hohe Bias-Spannung bewirkt durch das erzeugte große elektrische Kraftfeld eine starke Anziehung der moving finger **10**, was zu einem minimalen Plattenabstand führt.

Eine CV-Charakterisierung an dichten Referenzsensoren zeigt, wie bereits beschrieben und in Fig. 1 dargestellt, einen symmetrischen und typischen hyperbolischen Verlauf der Kapazität bis in den Anschlagsbereich (over force stopper). Bei undichten Sensoren **1** ist dieser symmetrische Verlauf der Sensorkapazität nachhaltig gestört.

Ursache hierfür sind in die Kavität eingedrungene, partiell an den Sensorfingern **5**, **7** und **10** anhaftende und polarisierte Partikel der Prüfflüssigkeit. Hierbei bewirken Oberflächenkräfte eine lokale Verstärkung der Anziehungs- bzw. Abstoßungsreaktionen zwischen den Sensorfingern **5**, **7** und **10**. Durch die auftretende hohe Feldstärkekonzentration kommt es in diesem Bereich zu einer elastischen Verformung der Fingerstruktur **5, 7** und **10** und dabei zu einer weiteren Verringerung des Abstandes, der im Extremfall zu einer Berührung der betreffenden Finger **5**, **7** und **10** führen kann.

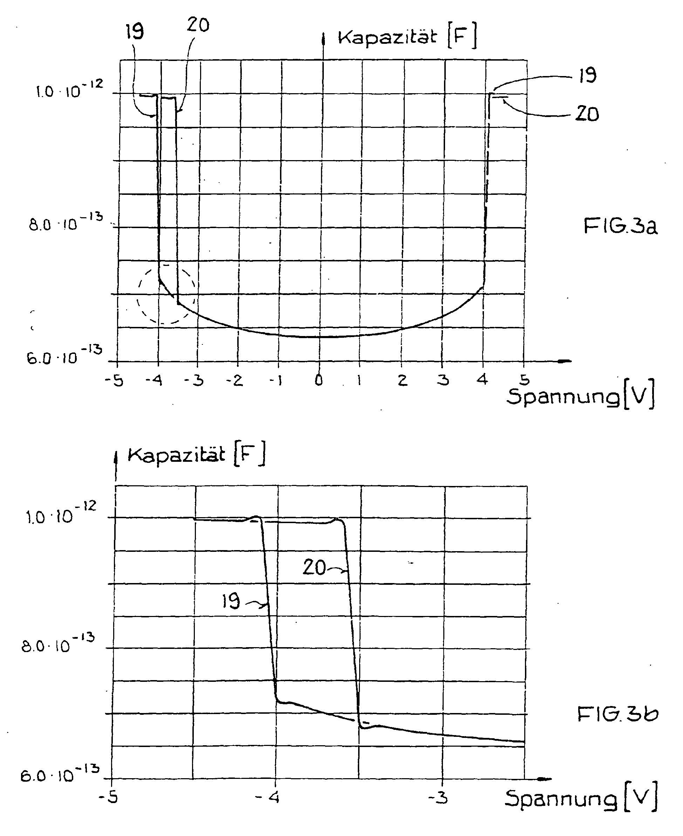

Dieses Sensorverhalten ist an der CV-Charakteristik in einer spontanen, vorzeitigen und häufig unsymmetrischen Kapazitätsänderung erkennbar, wie aus den **Fig. 3a, b** hervor geht. Die Fig. 3a zeigt eine erste Kurve **19,** die den typischen Verlauf der Kapazitätsänderung nach der beschriebenen erweiterten Prüfmethode eines dichten Sensors **1** darstellt. Bei einer Spannung von ca. +4,0 V und ―4,0 V steigt die Kapazität des Sensors von ca. 7·10⁻¹³ F steil an, bis die Kapazität jeweils bei ca. 1·10⁻¹² F im Anschlagsbereich endet.

Fig. 3a zeigt noch eine zweite Kurve **20,** die den typischen Verlauf der Kapazitätsänderung nach der beschriebenen erweiterten. Prüfmethode eines undichten Sensors **1** mit einer Leckrate im Bereich von ca. 10⁻⁴ mbar·dm³·s⁻¹ darstellt. Im positiven Spannungsbereich erfolgt wie bei einem dichten Sensor **1** eine starke Änderung der Kapazität bei ca. +4,0 V von wiederum ca. 7·10⁻¹³ F bis ca. 1·10⁻¹² F (Anschlagsbereich). Im Gegensatz hierzu erfolgt die gleich starke Änderung der Kapazität bereits bei ―3,5 V, was zum unsymmetrischen Verlauf der Kurve **20** führt, wie aus Fig. 3a deutlich zu entnehmen ist.

In Fig. 3b ist der starke Anstieg der Kapazität im negativen Spannungsbereich nochmals vergrößert dargestellt. Hieraus wird deutlich, dass der starke Anstieg der Kapazität von ca. 7·10⁻¹³ F bis ca. 1·10⁻¹² F im Anschlagsbereich bei beiden Kurven **19**, **20** annähernd gleich verläuft, jedoch der starke Kapazitätsanstieg des dichten Sensors **1** gemäß der Kurve **19** bei ―4,0 V erfolgt, während der starke Kapazitätsanstieg des undichten Sensors **1** gemäß der Kurve **20** bereits bei ―3,5 V erfolgt.

Mit Hilfe der erweiterten Prüfmethode ist es folglich möglich, die Dichtigkeit bzw. Undichtigkeit eines mikromechanisch hergestellten Sensors **1**, der eine Leckrate im Bereich von ca. 10⁻⁴ mbar·dm³·s⁻¹ aufweist, eindeutig festzustellen. Als eindeutiges, elektrisch messbares Prüfkriterium ist es im Rahmen der Parameter-Prüfung in den Wafertest integrierbar.

Diese erweiterte Prüfmethode ist außerdem geeignet, weitere Schwachstellen des Sensors **1** (sticking, mouse bite, trench derivate, foreign material etc.) an hermetisch dichten Sensoren messtechnisch aufzudecken.

## Patentansprüche

1. Verfahren zur Dichtigkeitsprüfung von in einem hermetisch dichten Gehäuse angeordneten kapazitiven Sensoren (1), wobei die prozessierten Sensoren (1) in Form eines Wafers angeordnet sind, **dadurch gekennzeichnet, dass** der bereits gesägte Wafer mit den Sensoren (1) unter definierten Bedingungen in eine Prüfflüssigkeit eingetaucht, anschließend die Kapazität (C1, C2) jedes Sensors (1) gemessen und mit der Kapazität von Referenzsensoren verglichen wird.

2. Verfahren nach Anspruch 1, **dadurch gekennzeichnet, dass** der gesägte Wafer mit den Sensoren (1) vor dem Eintauchen in die Prüfflüssigkeit für einen definierten Zeitraum in einem Behälter ein erstes Mal einem Vakuum ausgesetzt wird.

3. Verfahren nach Anspruch 2, **dadurch gekennzeichnet, dass** nach dem ersten Aussetzen des gesägten Wafers mit den Sensoren (1) im Vakuum der Behälter mit der Prüfflüssigkeit geflutet wird.

4. Verfahren nach Anspruch 3, **dadurch gekennzeichnet, dass** der Wafer im Behälter nach der Flutung des Behälters mit der Prüfflüssigkeit ein zweites Mal für einen definierten Zeitraum einem Vakuum ausgesetzt wird.

5. Verfahren nach Anspruch 4, **dadurch gekennzeichnet, dass** nach dem zweiten Aussetzen des gesägten Wafers mit den Sensoren (1) im Vakuum im Behälter der normale Luftdruck hergestellt wird.

6. Verfahren nach Anspruch 5, **dadurch gekennzeichnet, dass** nach dem Herstellen des normalen Luftdrucks im Behälter für einen definierten Zeitraum ein Überdruck hergestellt wird.

7. Verfahren nach Anspruch 6, **dadurch gekennzeichnet, dass** nach dem herstellen des Überdrucks der gesägte Wafer mit den Sensoren (1) aus dem Behälter entnommen und getrocknet wird.

8. Verfahren nach Anspruch 7, **dadurch gekennzeichnet, dass** nach der Trocknung des gesägten Wafers mit den Sensoren (1) jeder Sensor (1) auf dem Wafer durch Messung seiner Kapazität (C1, C2) im Wafertest geprüft wird.

9. Verfahren nach Anspruch 2, **dadurch gekennzeichnet, dass** der bereits gesägte Wafer mit den Sensoren (1) für 30 min im Behälter einem Vakuum von 5·10⁻¹ mbar ausgesetzt wird.

10. Verfahren nach Anspruch 3, **dadurch gekennzeichnet, dass** der Behälter mit der Prüfflüssigkeit Flourinert Dielektrika Typ 3M FC40 geflutet wird.

11. Verfahren nach Anspruch 4, **dadurch gekennzeichnet, dass** der Wafer im Behälter nach der Flutung des Behälters mit der Prüfflüssigkeit ein zweites Mal für 30 min einem Vakuum von 5·10⁻¹ mbar ausgesetzt wird.

12. Verfahren nach Anspruch 6, **dadurch gekennzeichnet, dass** im Behälter für einen definierten Zeitraum von 1 Stunde ein Überdruck von 8 bar hergestellt wird.

13. Verfahren nach Anspruch 7, **dadurch gekennzeichnet, dass** der Wafer zur Trocknung bei Zimmertemperatur für 15 min in einer Stickstoffbox gelagert wird.

14. Verfahren nach Anspruch 1 oder 8, **dadurch gekennzeichnet, dass** die Messung der Kapazität (C1, C2) jedes Sensors (1) mittels eines LCR-Meters erfolgt.

15. Verfahren nach Anspruch 14, **dadurch gekennzeichnet, dass** zur Feststellung großer Leckraten die Kapazität (C1, C2) mit einer Mess-Wechselspannung von U=0,5 Vᵣₘₛ und einer Frequenz von f=400kHz gemessen wird.

16. Verfahren nach Anspruch 15, **dadurch gekennzeichnet, dass** zur Feststellung kleiner Leckraten der Mess-Wechselspannung eine zusätzliche Gleichspannung überlagert wird.

17. Verfahren nach Anspruch 16, **dadurch gekennzeichnet, dass** die Mess-Wechselspannung zum einen mit einer positiven zusätzlichen Gleichspannung und zum anderen mit einer negativen zusätzlichen Gleichspannung überlagert wird.

18. Verfahren nach Anspruch 17, **dadurch gekennzeichnet, dass** die Mess-Wechselspannung mit einer zusätzlichen Gleichspannung von 4,5 V überlagert wird.

## Claims

1. A procedure for testing the impermeability of capacitive sensors (1) which are arranged in a hermetically sealed housing, whereby the processed sensors (1) are arranged in the form of a wafer, **characterized in that** the already cut wafer with the sensors (1) is submerged under defined conditions in a test fluid, the capacity (C1, C2) of each sensor (1) is subsequently measured, and is compared with the capacity of reference sensors.

2. A procedure according to claim 1, **characterized in that** the cut wafer with the sensors (1) is subjected to a vacuum for a first time for a defined time period in a receptacle prior to being submerged in the test fluid.

3. A procedure according to claim 2, **characterized in that** after the cut wafer with the sensors (1) is first subjected to the vacuum, the receptacle is flooded with test fluid.

4. A procedure according to claim 3, **characterized in that** the wafer in the receptacle with the test fluid is subjected to a vacuum for a second time for a defined time period.

5. A procedure according to claim 4, **characterized in that** after the cut wafer with the sensors (1) is subjected to the vacuum for the second time, the normal air pressure is restored in the receptacle.

6. A procedure according to claim 5, **characterized in that** after the normal air pressure has been restored in the receptacle for a defined time period, an overpressure is created.

7. A procedure according to claim 6, **characterized in that** after the overpressure is created, the cut wafer with the sensors (1) is removed from the receptacle and dried.

8. A procedure according to claim 7, **characterized in that** after the cut wafer with the sensors (1) is dried, each sensor (1) on the wafer is tested in the wafer test by measuring its capacity (C1, C2).

9. A procedure according to claim 2, **characterized in that** the wafer which has already been cut with the sensors (1) is subjected to a vacuum of 5·10⁻¹ mbar in a receptacle for 30 mins.

10. A procedure according to claim 3, **characterized in that** the receptacle is flooded with the fluorinated dielectrics test fluid of type 3M FC40.

11. A procedure according to claim 4, **characterized in that** the wafer in the receptacle after the receptacle is flooded with the test fluid is subjected for a second time to a vacuum of 5·10⁻¹ mbar for 30 minutes.

12. A procedure according to claim 6, **characterized in that** in the receptacle, an overpressure of 8 bar is created for a defined time period of 1 hour.

13. A procedure according to claim 7, **characterized in that** the wafer is stored at room temperature in a nitrogen box for 15 minutes for drying purposes.

14. A procedure according to either of claims 1 or 8, **characterized in that** the measurement of the capacity (C1, C2) of each sensor (1) is conducted using an LCR meter.

15. A procedure according to claim 14, **characterized in that** in order to determine larger leakage rate, the capacity (C1, C2) is measured with a measured alternating voltage of U=0.5Vᵣₘₛ and a frequency of f=400 kHz.

16. A procedure according to claim 15, **characterized in that** in order to determine smaller leakage rates, the measured alternating voltage is superimposed by an additional d.c. voltage.

17. A procedure according to claim 16, **characterized in that** the measured alternating voltage is one the one hand superimposed with a positive additional d.c. voltage, and on the other, with a negative additional d.c. voltage.

18. A procedure according to claim 17, **characterized in that** the measured alternating voltage is superimposed by a d.c. voltage of 4.5V.

## Revendications

1. Procédé de contrôle d'étanchéité de capteurs capacitifs (1) disposés dans un boîtier hermétiquement étanche, les capteur (1) traités étant agencés sous forme de tranche, **caractérisé en ce que** la tranche déjà découpée est, avec les capteurs (1), dans des conditions définies, plongée dans un liquide de contrôle, puis la capacité (C1, C2) de chaque capteur (1) est mesurée et est comparée à la capacité de capteurs de référence.

2. Procédé selon la revendication 1, **caractérisé en ce que** la tranche découpée, avec les capteurs (1), est, avant d'être plongée dans le liquide de contrôle, exposée une première fois à un vide dans un caisson pendant une durée définie.

3. Procédé selon la revendication 2, **caractérisé en ce que**, après la première exposition au vide de la tranche découpée, avec les capteurs (1), le caisson est rempli avec le liquide de contrôle.

4. Procédé selon la revendication 3, **caractérisé en ce que**, après le remplissage du caisson avec le liquide de contrôle, la tranche dans le caisson est exposée une deuxième fois à un vide pendant une durée définie.

5. Procédé selon la revendication 4, **caractérisé en ce que**, après la deuxième exposition de la tranche découpée, avec les capteurs (1), au vide dans le caisson, la pression d'air normale est établie.

6. Procédé selon la revendication 5, **caractérisé en ce que**, après l'établissement de la pression d'air normale dans le caisson, une surpression est établie pendant une durée définie.

7. Procédé selon la revendication 6, **caractérisé en ce que**, après l'établissement de la surpression, la tranche découpée, avec les capteurs (1), est enlevée du caisson et séchée.

8. Procédé selon la revendication 7, **caractérisé en ce que**, après le séchage de la tranche découpée, avec les capteurs (1), chaque capteur (1) est testé dans le wafertest sur la tranche par la mesure de sa capacité (C1, C2).

9. Procédé selon la revendication 2, **caractérisé en ce que** la tranche déjà découpée, avec les capteurs (1), est exposée à un vide de 5.10⁻¹ mbar dans le caisson pendant 30 minutes.

10. Procédé selon la revendication 3, **caractérisé en ce que** le caisson est rempli du liquide de contrôle Flourinert Dielektrika type 3M FC40.

11. Procédé selon la revendication 4, **caractérisé en ce que** la tranche dans le caisson, après le remplissage du caisson avec le liquide de contrôle, est exposée une deuxième fois pendant 30 minutes à un vide de 5.10⁻¹ mbar.

12. Procédé selon la revendication 6, **caractérisé en ce que**, dans le caisson, une surpression de 8 bars est établie pendant une durée définie de 1 heure.

13. Procédé selon la revendication 7, **caractérisé en ce que** la tranche, pour le séchage, est entreposée dans un caisson d'azote pendant 15 minutes à la température ambiante.

14. Procédé selon la revendication 1 ou 8, **caractérisé en ce que** la mesure de la capacité (C1, C2) de chaque capteur (1) est effectuée au moyen d'un LCR-mètre.

15. Procédé selon la revendication 14, **caractérisé en ce que**, pour la constatation de grands taux de fuite, la capacité (C1, C2) est mesurée avec une tension alternative de mesure de U=0,5 Vms et une fréquence de f=400kHz.

16. Procédé selon la revendication 15, **caractérisé en ce que**, pour la constatation de petits taux de fuite, une tension continue supplémentaire est superposée à la tension alternative de mesure.

17. Procédé selon la revendication 16, **caractérisé en ce que**, à la tension alternative de mesure, se superpose d'une part une tension continue supplémentaire positive et, d'autre part, une tension continue supplémentaire négative.

18. Procédé selon la revendication 17, **caractérisé en ce que**, à la tension alternative de mesure, se superpose une tension continue supplémentaire de 4,5 V.
